(19) Europäisches Patentamt
European Patent Office
Office européen des brevets

(11) **EP 3 513 274 B1**

(12) **EUROPÄISCHE PATENTSCHRIFT**

(45) Veröffentlichungstag und Bekanntmachung des Hinweises auf die Patenterteilung:
**19.05.2021 Patentblatt 2021/20**

(21) Anmeldenummer: **17765452.2**

(22) Anmeldetag: **14.09.2017**

(51) Int Cl.:
*G06F 3/044* (2006.01)   *G01R 27/26* (2006.01)
*H03K 17/955* (2006.01)   *H03K 17/96* (2006.01)

(86) Internationale Anmeldenummer:
**PCT/EP2017/073118**

(87) Internationale Veröffentlichungsnummer:
**WO 2018/050737 (22.03.2018 Gazette 2018/12)**

(54) **VERFAHREN ZUM ERKENNEN EINER BERÜHRUNG EINES KAPAZITIVEN SENSORELEMENTS**

METHOD FOR DETECTING CONTACT ON A CAPACITATIVE SENSOR ELEMENT

PROCÉDÉ POUR RECONNAÎTRE UN EFFLEUREMENT D'UN ÉLÉMENT SENSIBLE CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.09.2016 DE 102016011272**

(43) Veröffentlichungstag der Anmeldung:
**24.07.2019 Patentblatt 2019/30**

(73) Patentinhaber: **KOSTAL Automobil Elektrik GmbH & Co. KG**
**58513 Lüdenscheid (DE)**

(72) Erfinder: **BORGMANN, Uwe**
**45665 Recklinghausen (DE)**

(74) Vertreter: **Kerkmann, Detlef**
**Leopold Kostal GmbH & Co. KG**
**An der Bellmerei 10**
**58513 Lüdenscheid (DE)**

(56) Entgegenhaltungen:
**DE-A1-102006 045 737     DE-A1-102010 041 464**
**US-A1- 2010 252 408**

## Beschreibung

Die Erfindung betrifft ein Verfahren zum Erkennen einer Berührung eines kapazitiven Sensorelements, wobei ein Kapazitätswert des Sensorelements mittels eines fortlaufend angewendeten Integrationsverfahrens gemessen wird, bei dem jeweils eine an einem Integrationskondensator mit einem bekannten Kapazitätswert anliegende Spannung mittels eines A/D-Wandlers gemessen und zu einer Sensoramplitude verarbeitet wird, wobei das zeitliche Verhalten der Sensoramplitude ausgewertet wird, indem eine Änderungsgeschwindigkeit der Sensoramplitude ermittelt wird.

Verfahren der hier angesprochenen Art werden verwendet, um kapazitive Berührungs- bzw. Annäherungssensoren auszuwerten. Ein solcher Sensor kann die Gegenwart und bei entsprechender Ausgestaltung auch den Ort einer Berührung oder der Annäherung durch ein Objekt, wie zum Beispiel einen Finger des Benutzers oder einen Stift, innerhalb eines empfindlichen Bereichs detektieren. Der berührungsempfindliche Bereich kann dabei beispielsweise einen Anzeigebildschirm überlagern. In einer Anzeigeanwendung kann es der Berührungs- bzw. Annäherungssensor dem Benutzer ermöglichen, direkt mit dem, was auf dem Bildschirm dargestellt wird, zu interagieren, und nicht nur indirekt mittels einer Maus oder einem ähnlichen Eingabegerät.

Es gibt eine Anzahl verschiedener Arten von Berührungssensoren, wie zum Beispiel resistive Berührungssensoren, Berührungssensoren mit akustischen Oberflächenwellen und kapazitive Berührungssensoren, wobei letztgenannte, mit denen eben insbesondere auch schon eine bloße Annäherung erfasst werden kann, inzwischen die größte Verbreitung erfahren haben.

Wenn ein Objekt die Oberfläche eines kapazitiven Berührungssensors berührt oder in dessen Nähe kommt, tritt eine Änderung des Kapazitätswertes des Sensorelements auf. Aufgabe eines zugeordneten Sensorsteuergerätes bzw. des durch dieses verwendeten Messverfahrens ist es, diese Kapazitätsänderung zu verarbeiten, um die diese auslösende Berührung oder Annäherung zu erfassen. Die besondere Schwierigkeit hierbei besteht darin, dass die Kapazitätswerte der Sensorelemente und insbesondere die zu erfassenden Änderungen sehr klein sind. Aus diesem Grunde bedient man sich zu ihrer Messung gerne sogenannter Integrationsverfahren, bei denen in mehreren aufeinander folgenden Zyklen kleine Ladungsmengen von dem Sensorelement, dessen Kapazitätswert relativ klein und veränderlich ist, auf einen Integrationskondensator mit einem bekannten festen und deutlich größeren Kapazitätswert übertragen werden. Die an dem Integrationskondensator nach einer vorgegebenen Anzahl solcher Integrationszyklen anliegende Spannung wird dann mittels eines A/D-Wandlers gemessen und zu einer Sensoramplitude verarbeitet.

Die deutsche Offenlegungsschrift DE 10 2006 045 737 A1 zeigt ein Verfahren zum Erkennen einer Berührung eines kapazitiven Sensorelements, bei dem eine an einem mit dem Sensorelement kooperierenden Integrationskondensator anliegende Spannung gemessen, und deren zeitliches Verhalten zur Bestimmung des Betätigungszustandes des Sensorelements ausgewertet wird.

Die US 2010/0252408 A1 zeigt ebenfalls ein Verfahren zum Erkennen einer Berührung eines kapazitiven Sensorelements. Bei diesem Verfahren wird geprüft, ob die Änderungsgeschwindigkeit des Sensorsignals für einen bestimmten Zeitraum in einem vorherbestimmten Bereich liegt, und ob der Absolutwert des Sensorsignals während dieser Zeit ebenfalls über einem Schwellwert liegt.

Durch die deutsche Offenlegungsschrift DE 10 2010 041 464 A1 ist ein Verfahren zum Erkennen einer Berührung eines kapazitiven Sensorelements gemäß dem Oberbegriff des Patentanspruchs 1 bekannt geworden.

Die zuvor beschriebene Sensoramplitude wird im Zuge des dort gezeigten Verfahrens fortlaufend erfasst und mit einem vorgegebenen Amplitudenschwellwert verglichen. Solange sich kein Finger bzw. anderes zu erfassendes Objekt dem Sensorelement nähert, verharrt die Sensoramplitude auf einem im Wesentlichen konstanten Basiswert. Bei der Annäherung eines Fingers an das Sensorelement steigt die Sensoramplitude dagegen deutlich an. Das tatsächliche Erkennen einer Berührung des kapazitiven Sensorelements erfolgt, wenn die Sensoramplitude einen zuvor festgelegten Amplitudenschwellwert überschritten hat.

Tatsächlich ist die Sensoramplitude von vielen Parametern abhängig. So haben nicht nur die Form bzw. die Abmessungen des bedienenden Körperteils des Bedieners, also z.B. dünnere oder dickere Finger Einfluss auf diese Sensoramplitude, es spielt etwa auch die Positionierung dieses Körperteils über dem Sensor eine wichtige Rolle. So ist die höchste Empfindlichkeit typischer Weise direkt über dem Schwerpunkt des Sensorelements gegeben und nimmt zum Rand desselben hin ab. Diese Einflüsse können nur in geringem Maße durch die Elastizität der Hautoberfläche bzw. des Fingers ausgeglichen werden.

Ein sicheres Auslösen der mit der Erkennung der Berührung verbundenen Funktion kann bei typischen Anordnungen von Sensorflächen insbesondere im Kraftfahrzeug und der beschriebenen Auswertung über einen zuvor festgelegten Amplitudenschwellwert nicht sichergestellt werden.

Eine mögliche Bedienung der sensorischen Funktion mit Handschuhen verschärft das Problem zusätzlich. Bei einer Auslegung des

Amplitudenschwellwerts, die eine Bedienung mit Handschuhen ermöglicht, würde bei einer Bedienung ohne Handschuhe bereits mehrere Millimeter über der Sensoroberfläche eine fehlerhafte Erkennung einer vermeintlichen Berührung erfolgen.

Eine ggf. erwünschte aktive haptische Rückmeldung durch eine Aktuatorik wie etwa eine Hubmagneten, einen Vibrationsmotor oder ähnliches erfordert ebenso eine Berührung der Oberfläche. Dazu muss beim Stand der Technik die kapazitive Sensorik mit eine Kraftsensorik ergänzt werden, was technisch erheblich komplexer und teurer ist.

Das Verfahren gemäß der vorliegenden Erfindung hat gegenüber dem zuvor beschriebenen Stand der Technik den Vorteil, eine gleich hohe Empfindlichkeit bezüglich der Erkennung tatsächlicher Berührungen des Sensorelements praktisch unabhängig von den geschilderten Einflussparametern wie Größe, Form und Positionierung des Fingers oder sogar unterschiedlich dicke Handschuhe sicher zu stellen.

Dies gelingt erfindungsgemäß dadurch, dass eine Berührung des Sensorelements erkannt wird, wenn die Änderungsgeschwindigkeit zwischen einem Änderungsminimalwert und einem Änderungsmaximalwert liegt, und die Sensoramplitude nach Ablauf einer vorgegebenen Zeitspanne danach zum einem Wartezeitpunkt zwischen einem Amplitudenminimalwert und einem Amplitudenmaximalwert liegt.

Das erfindungsgemäße Verfahren macht sich die Tatsache zu Nutze, dass das zeitliche Verhalten der Sensoramplitude bei einer Annäherung oder Berührung des Sensorelements von den genannten Einflussparametern weitgehend unabhängig ist.

Bei der Annäherung eines Fingers (oder anderen Körperteils) an das

Sensorelement aus größerer Entfernung wird die Sensoramplitude stetig größer. Bei der Berührung des Sensorelements wird der Finger dann abgebremst und im Rahmen seiner Elastizität verformt. Dieser Ablauf spiegelt sich im zeitlichen Verhalten der Sensoramplitude dergestalt wider, dass diese zunächst deutlich langsamer steigt und beim vollständigen Aufliegen des Fingers dann nahezu konstant bleibt.

Dieses Verhalten ist weitgehend unabhängig von der Größe des Fingers, der Positionierung des Fingers auf der Sensorfläche und davon, ob Handschuhe genutzt werden oder nicht. Erkennt man daher den Zeitpunkt, bei dem die Sensoramplitude deutlich langsamer steigt, oder einen Zeitpunkt kurz danach, in dem die Sensoramplitude nahezu konstant ist, kann man das Berühren des Fingers auf dem Sensorelement sicher detektieren.

In einer vorteilhaften Ausgestaltung des erfindungsgemäßen Verfahrens ist vorgesehen, dass die Änderungsgeschwindigkeit als Anstiegszeit bestimmt werden kann, die die Sensoramplitude benötigt, um von einem Änderungsstartwert auf einen Änderungszielwert zu steigen.

Möglicherweise fehlerhafte Erkennungen einer Berührung des Sensorelements können dadurch vermieden werden, dass eine erkannte Berührung des Sensorelements als ungültig verworfen wird, wenn die Sensoramplitude zu einem Prüfzeitpunkt nach dem Wartezeitpunkt um mehr als eine zulässige Plustoleranz nach oben oder eine Minustoleranz nach unten von ihrem Wert zum Wartezeitpunkt abweicht..

Weitere vorteilhafte Ausgestaltungen des erfindungsgemäßen Verfahrens ergeben sich aus der nachfolgenden Beschreibung einer möglichen Ausführung der Erfindung.

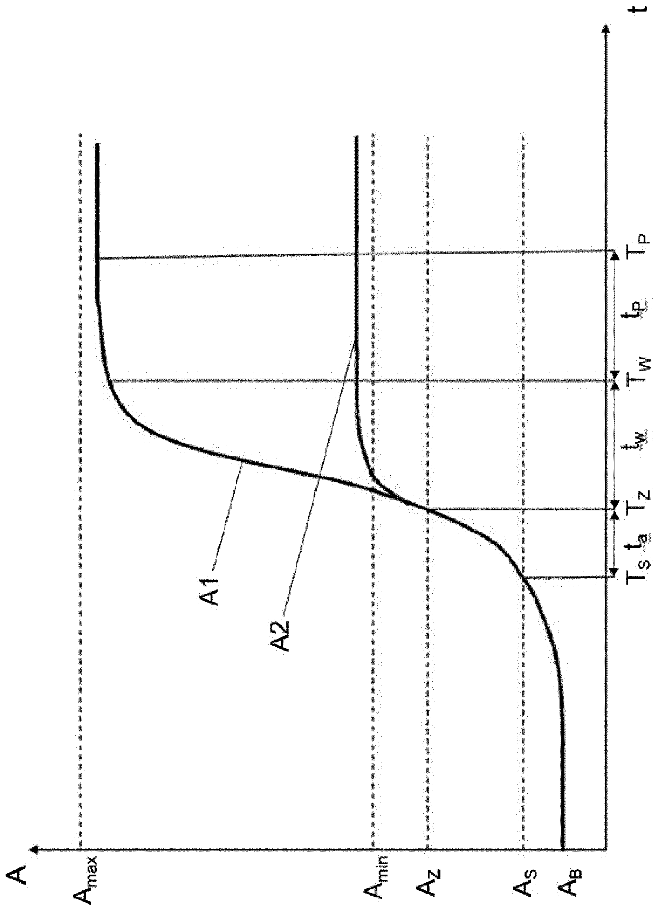

Nachfolgend ist die Erfindung unter Bezugnahme auf die beigefügte Zeichnung erläutert.

Dabei zeigt die einzige Figur den zeitlichen Verlauf der Sensoramplitude A bei Annäherung und Berührung eines berührungsempfindlichen kapazitiven Sensorelements für zwei unterschiedliche Anwendungsfälle.

So ist in der oberen Messkurve der zeitliche Verlauf der erfassten Sensoramplitude A1 bei Annäherung und anschließender Berührung des berührungsempfindlichen Sensorelements durch einen großen Finger ohne Handschuh in der Mitte des Sensorelements gezeigt. Die untere Messkurve dagegen zeigt den entsprechenden Verlauf der Sensoramplitude A2 bei der Betätigung des gleichen Sensorelements durch einen kleinen Finger mit Handschuh am Rand des Sensorelements.

Diese beiden Messkurven bzw. Sensoramplituden A1 und A2 stellen somit Grenzfälle mit extrem unterschiedlichen Bedingungen dar, die aber beide mit dem gleichen Erkennungsverfahren bewältigt werden sollen.

Vor der Annäherung des Fingers verharrt die Sensoramplitude A beider Messkurven auf einem Basiswert $A_B$, der im Wesentlichen konstant ist, bzw. sich nur langsam aufgrund äußerer Einflüsse wie z.B. Temperaturschwankungen ändert. Sobald die Annäherung eines Fingers an das Sensorelement erfolgt, beginnt die Sensoramplitude A deutlich zu steigen. Zur Erlangung eines notwendigen Kriteriums für die Erkennung einer tatsächlichen Berührung des Sensorelements wird die Änderungsgeschwindigkeit $\Delta A/\Delta t$ der Sensoramplitude A herangezogen. Diese Änderungsgeschwindigkeit $\Delta A/\Delta t$ wird in dem vorliegenden Ausführungsbeispiel konkret dadurch ermittelt, dass eine Anstiegszeit $t_a$ bestimmt wird, die die Sensoramplitude A benötigt, um von einem Änderungsstartwert $A_s$ zum Zeitpunkt Ts auf einen Änderungszielwert Az zum Zeitpunkt Tz zu steigen. Diese Anstiegszeit ta = Tz - Ts ist umgekehrt proportional zur Änderungsgeschwindigkeit $\Delta A/\Delta t$ der Sensoramplitude A und kann somit als Maß für die gesuchte Änderungsgeschwindigkeit verwendet werden. Der Änderungsstartwert $A_s$ und der Änderungszielwert Az sind in diesem Ausführungsbeispiel Parameter, die für die vorliegende physikalische Realisierung des Sensorelements experimentell so bestimmt werden, dass mit ihnen die Änderungsgeschwindigkeit $\Delta A/\Delta t$ in einem Bereich erfasst wird, in dem diese für den größten Teil der Anwendungsfälle möglichst ähnlich ist. Im gezeigten Beispiel der beiden Messkurven mit den Sensoramplituden A1 und A2 ist die Änderungsgeschwindigkeit $\Delta A/\Delta t$ in dem ausgewählten Bereich sogar identisch.

Als notwendiges Kriterium für die Erkennung einer tatsächlichen Berührung des Sensorelements muss die Änderungsgeschwindigkeit $\Delta A/\Delta t$ der Sensorampli-

tude A zwischen einem Änderungsminimalwert $(\Delta A/\Delta t)_{min}$ und einem Änderungsmaximalwert $(\Delta A/\Delta t)_{max}$ liegen, bzw. die ermittelte Anstiegszeit $t_a$ in einem vorgegebenen Bereich zwischen einem Minimalwert $t_{a\,min}$ und einem Maximalwert ta max liegen.

Ein solches Kriterium, das auf die Dynamik des Signalverlaufs reagiert, reagiert damit selbstverständlich auch sehr empfindlich auf mögliche Störungen des Signals. Aus diesem Grunde ist zur sicheren Erkennung einer tatsächlichen Berührung des Sensorelements ein weiteres Kriterium erforderlich.

Zur Definition eines solchen Kriteriums wird wiederum die Sensoramplitude A selbst betrachtet. Im Gegensatz zu einer Störung, etwa durch elektromagnetische Impulse, muss bei einer tatsächlichen Berührung die Sensoramplitude A einen Wert aufweisen, der deutlich über dem eingangs erwähnten Basiswert $A_B$ liegt. Andererseits würde eine Sensoramplitude A, die erheblich höher als ein nach den physikalischen Gegebenheiten maximal erwartbarer Wert ist, auch wiederum auf eine Störung hindeuten, so dass ein maximaler Amplitudenwert $A_{max}$ definiert wird, unter dem Sensoramplitude A liegen muss, um von einem ungestörten Signal ausgehen zu können.

Das weitere Kriterium verlangt daher, dass die Sensoramplitude A zu einem Wartezeitpunkt Tw, der dem Ablauf einer vorgegebenen Zeitspanne $t_w$ nach dem Zeitpunkt Tz des Überschreitens des Änderungszielwerts Az entspricht, zwischen einem Amplitudenminimalwert Amin und einem Amplitudenmaximalwert $A_{max}$ liegt. Die Vorgabe der Zeitspanne $t_w$, die einer Wartezeit bis zum Erreichen einer zumindest annähernd konstanten Sensoramplitude A entspricht, erfolgt dabei durch Multiplikation der zuvor ermittelte Anstiegszeit ta mit einem konstanten Faktor w, der wiederum von der physikalischen Realisierung des Sensorelements abhängt und experimentell bestimmt werden muss, so dass also gelten muss $t_w$ = w* ta und somit $T_W = T_Z$ + w* ta

Die Sensoramplituden A1 und A2 der beiden Messkurven zum Wartezeitpunkt Tw sind zwar deutlich unterschiedlich, was auf die geschilderten unterschiedlichen physikalischen Bedingungen der Anwendungsfälle zurückzuführen ist. Sie liegen jedoch beide in dem durch den Amplitudenminimalwert $A_{min}$ und den Amplitudenmaximalwert $A_{max}$ definierten Bereich, so dass in beiden Fällen eine gültige Berührung des Sensorelements festgestellt wird.

Zur weiteren Absicherung der Sensorauswertung, um insbesondere fehlerhafte positive Erkennungen noch sicherer zu vermeiden, kann noch ein drittes Kriterium definiert werden. Dieses zielt darauf ab, zu bestätigen, dass die Sensoramplitude A zum Wartezeitpunkt Tw nicht nur zwischen dem Amplitudenminimalwert Amin und dem Amplitudenmaximalwert $A_{max}$ liegt, sondern auch bereits annähernd konstant ist. Dazu wird zu einem Prüfzeitpunkt $T_P$ überprüft, ob sich die Sensoramplitude A um nicht mehr als eine zulässige Plustoleranz $\delta A+$ bzw. Minustoleranz $\delta A-$ von ihrem Wert zum Wartezeitpunkt

$T_W$ nach oben oder unten verändert hat.

Der Prüfzeitpunkt $T_P$ soll dabei möglichst nah an dem Wartezeitpunkt Tw liegen, aber zumindest so viel Zeit lassen, wie die Sensoramplitude A nach Erreichen eines annähernd konstanten Wertes benötigt, um einen entprellten Zustand anzunehmen. Daher wird eine Prüfzeitspanne $t_p$ bestimmt, die dieser Anforderung für die vorliegende Sensoranordnung genügt, und der Prüfzeitpunkt auf $T_P = T_W + t_p$ festgelegt.

Für die Sensoramplitude A muss zu diesem Prüfzeitpunkt $T_P$ gelten:

$$A(T_W) - \delta A- \; < \; A(T_P) \; < \; A(T_W) + \delta A+$$

Eine nach den vorher geschilderten Kriterien als gültig erkannte Berührung des Sensorelements wird in diesem letzten Schritt daher wieder als ungültig verworfen, wenn die Sensoramplitude A zu dem Prüfzeitpunkt $T_P$ um mehr als die zulässige Plustoleranz $\delta A+$ nach oben oder um mehr als die zulässige Minustoleranz $\delta A-$ nach unten von ihrem Wert zum Wartezeitpunkt Tw abweicht.

## Patentansprüche

1. Verfahren zum Erkennen einer Berührung eines kapazitiven Sensorelements, wobei ein Kapazitätswert des Sensorelements mittels eines fortlaufend angewendeten Integrationsverfahrens gemessen wird, bei dem jeweils eine an einem Integrationskondensator mit einem bekannten Kapazitätswert anliegende Spannung mittels eines A/D-Wandlers gemessen und zu einer Sensoramplitude (A) verarbeitet wird, wobei das zeitliche Verhalten der Sensoramplitude (A) ausgewertet wird, indem eine Änderungsgeschwindigkeit , $(\Delta A/\Delta t)$ , der Sensoramplitude (A) ermittelt wird,

   dadurch gekennzeichnet, dass eine Berührung des Sensorelements erkannt wird, wenn die Änderungsgeschwindigkeit, $(\Delta A/\Delta t)$ , zwischen einem Änderungsminimalwert, $(\Delta A/\Delta t)_{min}$, und einem Änderungsmaximalwert , $(\Delta A/\Delta t)_{max}$ , liegt, und die Sensoramplitude (A) nach Ablauf einer vorgegebenen Zeitspanne ($t_w$) danach zu einem Wartezeitpunkt (Tw) zwischen einem Amplitudenminimalwert (Amin) und einem Amplitudenmaximalwert ($A_{max}$) liegt.

2. Verfahren nach Anspruch 1, dadurch gekennzeichnet, dass die Änderungsgeschwindigkeit , $(\Delta A/\Delta t)$ , der Sensoramplitude (A) als Anstiegszeit (ta) bestimmt wird, die die Sensoramplitude (A) benötigt, um von einem Änderungsstartwert (As) auf einen Änderungszielwert (Az) zu steigen.

3. Verfahren nach Anspruch 1 oder 2, dadurch ge-

**kennzeichnet, dass** eine erkannte Berührung des Sensorelements als ungültig verworfen wird, wenn die Sensoramplitude (A) zu einem Prüfzeitpunkt (T$_P$) nach dem Wartezeitpunkt (Tw) um mehr als eine zulässige Plustoleranz , δA+, nach oben oder eine Minustoleranz , δA-, nach unten von ihrem Wert zum Wartezeitpunkt (Tw) abweicht.

## Claims

1. Method for detecting contact with a capacitive sensor element, a capacitance value of the sensor element being measured by means of a continuously applied integration method, in which in each case a voltage applied to an integration capacitor with a known capacitance value is measured by means of an A/D converter and processed to form a sensor amplitude (A), the temporal behaviour of the sensor amplitude (A) being evaluated by determining a rate of change, (ΔA/Δt), of the sensor amplitude (A), **characterized in that** contact with the sensor element is detected when the rate of change, (ΔA/Δt), lies between a change minimum value, (ΔA/Δt)$_{min}$, and a change maximum value, (ΔA/Δt)$_{max}$, and the sensor amplitude (A) after a predetermined period of time (t$_w$) then lies at a waiting time (Tw) between an amplitude minimum value (Amin) and an amplitude maximum value (Amax).

2. Method according to claim 1, **characterized in that** the rate of change, (ΔA/Δt), of the sensor amplitude (A) is determined as the rise time (ta) required for the sensor amplitude (A) to rise from a change start value (As) to a change target value (Az).

3. Method according to claim 1 or 2, **characterized in that** a detected contact of the sensor element is rejected as invalid if the sensor amplitude (A) at a test time (T$_P$) after the waiting time (Tw) deviates by more than a permissible plus tolerance, δA+, upwards or a minus tolerance, δA-, downwards from its value at the waiting time (Tw).

## Revendications

1. Procédé pour détecter un contact avec un élément capteur capacitif, selon lequel on mesure une valeur de capacité de l'élément capteur au moyen d'un procédé d'intégration appliqué en continu, selon lequel on mesure chaque fois une tension appliquée à un condensateur d'intégration ayant une valeur de capacité connue au moyen d'un convertisseur A/N et on la traite pour former une amplitude (A) du capteur, le comportement dans le temps de l'amplitude (A) du capteur étant évalué en déterminant une vitesse de variation (ΔA/Δt) de l'amplitude (A) du capteur, **caractérisé en ce que** le contact avec l'élément de capteur est détecté lorsque le taux de changement, (ΔA/Δt), se situe entre une valeur minimale de changement, (ΔA/Δt)$_{min}$, et une valeur maximale de changement, (ΔA/Δt)$_{max}$, et l'amplitude du capteur (A) après une durée prédéterminée (t$_w$) se situe alors à un temps d'attente (Tw) compris entre une valeur minimale d'amplitude (A$_{min}$) et une valeur maximale d'amplitude (A$_{max}$).

2. Procédé selon la revendication 1, **caractérisé en ce que** le taux de variation, (ΔA/Δt), de l'amplitude du capteur (A) est déterminé comme le temps de montée (ta) nécessaire pour que l'amplitude du capteur (A) augmente d'une valeur de départ de variation (As) à une valeur cible de variation (Az).

3. Procédé selon la revendication 1 ou 2, **caractérisé en ce qu'**un contact détecté de l'élément de capteur est rejeté comme non valable si l'amplitude du capteur (A) à un moment de test (T$_P$) après le temps d'attente (Tw) s'écarte de plus d'une tolérance plus admissible, δA+, vers le haut ou d'une tolérance moins admissible, δA-, vers le bas par rapport à sa valeur au moment d'attente (Tw).

EP 3 513 274 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006045737 A1
- US 20100252408 A1
- DE 102010041464 A1